# EUROPÄISCHE PATENTSCHRIFT

(11) **EP 2 983 466 B1**
(45) Veröffentlichungstag und Bekanntmachung des Hinweises auf die Patenterteilung: **13.02.2019**
(21) Anmeldenummer: 14719615.8
(22) Anmeldetag: 09.04.2014
(51) Int. Cl.: F21V 23/00, F21V 23/02, H05B 33/08, F21V 23/04, H05B 37/02, F21K 9/20, H02J 1/00, H01H 9/04, A01K 63/06, H05K 5/00, H05K 5/06

(54) **UNTERWASSER-SCHALTEINHEIT**
UNDERWATER SWITCH UNIT
UNITÉ DE COMMUTATION SUBAQUATIQUE

(30) Priorität: 09.04.2013 DE 102013005973
(43) Veröffentlichungstag der Anmeldung: 17.02.2016
(73) Patentinhaber: Oase GmbH, 48477 Hörstel (DE)
(72) Erfinder: HANKE, Andreas, 49078 Osnabrück (DE)
(74) Vertreter: Busse & Busse
(86) Internationale Anmeldenummer: PCT/EP2014/000948
(87) Internationale Veröffentlichungsnummer: WO 2014/166629

(56) Entgegenhaltungen:
- EP-A1- 0 418 431
- WO-A1-2012/038237
- WO-A1-2013/156146
- WO-A2-2008/067402
- WO-A2-2008/149236
- JP-A- 2004 286 860
- US-A- 5 211 469
- US-A1- 2004 182 765
- US-A1- 2005 248 944
- US-A1- 2006 023 454

## Beschreibung

Die vorliegende Erfindung betrifft eine Unterwasser-Schalteinheit zur Spannungsversorgung von Elektrogeräten insbesondere im Kleinspannungsbereich bis 30 Volt, vorzugsweise für 12-Volt- bzw. 24-Volt-Systeme. Hierbei kann es sich um Gleich- oder Wechselstromsysteme handeln.
Zur Schaltung von Elektrogeräten wie Leuchten, Pumpen oder Schaltventilen kommen im Teich- und Aquaristikbereich standardmäßig Schalteinheiten in Form von Schaltschränken außerhalb des Wassers zum Einsatz. Zur Versorgung jedes einzelnen Endgerätes werden dann Kabel verlegt, die entsprechend lang sein müssen. Hieraus ergeben sich hohe Strom- und Kabelkosten sowie erhöhte Kosten für die Verlegung. Ein entsprechend ausgebildeter Gegenstand ist beispielhaft der WO 2008/067402 A2 zu entnehmen.

Eine Unterwasser-Schalteinheit zur Spannungsversorgung von Elektrogeräten ergibt sich aus der WO 2012/038237 A1. Die vorbekannte Schalteinheit sieht in Reihe geschaltete Kontaktunterbrecher und elektronische Schaltelemente in beiden Adern einer zweiadrigen Leitung, für 1-phasigen Wechselstrom wie auch in allen drei Adern einer dreiadrigen Drehstrom-Leitung vor, um die Schalteinheit elektrisch abzutrennen.

Es ist Aufgabe der vorliegenden Erfindung, Materialleinsatz und Stromverbrauch für die Versorgung von insbesondere im oder auch am Wasser anzuordnenden Elektrogeräten zu minimieren.
Die Aufgabe wird gelöst durch einen Gegenstand gemäß Anspruch 1. Vorteilhafte Ausbildungen der Erfindung sind den auf Anspruch 1 rückbezogenen Unteransprüchen sowie der nachfolgenden Beschreibung zu entnehmen.

Erfindungsgemäß ist vorgesehen, dass die Unterwasser-Schalteinheit mit einem insbesondere wasserdicht ausgebildeten Gehäuse, in dem eine Elektronikeinheit angeordnet ist, versehen ist. Über die Elektronikeinheit ist eine über einen Eingangsanschluss der Unterwasser-Schalteinheit anlegbare Eingangsspannung auf mehrere Ausgangsanschlüsse der Unterwasser-Schalteinheit parallel verteilbar, wobei zumindest zwei der Ausgangsanschlüsse über zumindest ein Schaltelement der Unterwasser-Schalteinheit separate voneinander spannungsbeaufschlagt werden können, und wobei die regelunfähige Unterwasser-Schalteinheit einen Datenbusanschluss mit zugehöriger Datenbus-Schnittstelle umfasst, mit der ein Informationssignal bereffend die Spannungsbeaufschlagung eines Ausgangsanschlusses erfassbar ist.

Unter regelunfähig ist hier eine Unterwasser-Schalteinheit zu verstehen, die keine Verarbeitung und Weiterleitung von Regelsignalen zur Dimmung, Farbänderung oder Frequenzsteuerung angeschlossener Elektrogeräte vornehmen kann. Die Funktionalität der erfindungsgemäßen Unterwasser-Schalteinheit ist einfach. Die Einheit ist entsprechend kostengünstig aufgebaut dahingehend, dass lediglich die über einen Eingangsanschluss anliegende Spannung, insbesondere eine 12-Volt- oder 24-Volt-Gleichspannung auf die Ausgänge parallel verteilt und separat aufgeschaltet werden kann. Allenfalls ist die Unterwasser-Schalteinheit zur Statusabfrage wie beispielsweise Stromfluss über die Anschlüsse, Schaltzustand der Anschlüsse, Spannung an den einzelnen Anschlüssen sowie etwaigen Komponenten und optional zur Übermittlung einer Temperaturinformation befähigt. Es ist also eine reine Schalteinheit, die ohne Controllerfunktionen für die Elektrogeräte des Teich- und Aquaristikbereichs zum Betrieb dieser Geräte vorgesehen ist. Vorzugsweise handelt es sich bei den Elektrogeräten um Endgeräte wie z.B. LED-Leuchten oder Pumpen. Es kann sich jedoch auch um beispielsweise Magnetventile handeln.

Zum Ansteuern des zumindest einen Schaltelements verfügt die Unterwasser-Schalteinheit (nachfolgend auch "Schalteinheit") über einen Datenbus-Anschluss in Form einer mit einem Datenbusanschluss verbundenen Datenbus-Schnittstelle, über die beispielsweise Signale eines DMX-Busses bzw. DMX-RDM-Busses verarbeitet werden können.

Im Wasser anzuordnende Systeme wie Pumpen, Leuchten oder Schaltventile können dann von der zentralen und z.B. im Wasser anzuordnenden Schalteinheit aus über kurze Kabelwege mit Strom versorgt werden. Es ist lediglich eine längere Leitung zur Unterwasser-Schalteinheit selbst sowie eine längere Leitung für das Datenkabel, über das das Bussignal vermittelt wird, notwendig. Die Leitungslängen können somit beispielsweise bei der Anordnung von vier Endgeräten in Form von Unterwasser-Leuchten, die ansonsten separat von einem Schaltschrank hätten versorgt werden müssen, ungefähr halbiert werden.

Dies wirkt sich kostensparend auf Material und Stromverbrauch aus und verringert den Montageaufwand..

Über das Datenbussignal können Informationen zur Schalteinheit geliefert werden, mittels derer die von der Unterwasser-Schalteinheit versorgten Elektro- oder Endgeräte separat, paarweise oder in Gruppen ein- oder ausgeschaltet werden können.

Vorzugsweise ist jedem Ausgangsanschluss jeweils ein Schaltelement zugeordnet, so dass bei trotzdem hoher Simplizität der Schaltung eine ausreichende Flexibilität im Sinne einer unterschiedlichen Verschaltung zu jeweiligen Gruppen von Endgeräten möglich ist.

Vorzugsweise ist die Unterwasser-Schalteinheit mit zumindest vier Ausgangsanschlüssen versehen, über die entsprechend vier Endgeräte versorgt werden können. Die Unterwasseranschlüsse sind hierbei zum wasserdichten Anschluss eines elektrogeräteseitig vorzusehenden Steckkontakts ausgebildet.

Alternativ oder ergänzend kann die Unterwasser-Schalteinheit mit zumindest einem an einen Ausgangsanschluss anschließbaren Verteiler versehen sein, über den mehrere Endgeräte an einen Ausgang anschließbar sind. Hierdurch kann dann eine sehr hohe Anzahl an Endgeräten gleichzeitig geschaltet werden, begrenzt durch die zulässigen Stromstärken im Gerät.

Das Schaltelement ist auf eine Schaltfrequenz von mindestens 100 Hz ausgelegt, so dass beispielsweise ein Unterwasser-Lichtspiel mit einer Vielzahl von verschiedenfarbigen Endgeräten, z.B. LED-Leuchtmodule, dennoch komplexe Effekte erzeugen kann.

In einer weiteren erfinderischen Ausbildung der Unterwasser-Schalteinheit ist diese mit zumindest zwei Schaltelementen versehen, wobei die Schaltelemente jeweils elektronische Schaltelement sind. Diese sind insbesondere als Transistor, hier insbesondere als MOSFET, oder als Thyristor bzw. Triac ausgebildet und können dann entsprechend jeweils Gleichstrom (Transistor) oder Wechselstrom (Thyristor/Triac) schalten. Vorzugsweise handelt es sich um 12 Volt bzw. 24 Volt Gleichstromsysteme und entsprechende Schaltelemente wie beispielsweise Power-MOSFETS.

Für die Elektrogeräte ist die Elektronikeinheit der Unterwassereinheit somit nur zum Ein- und Ausschalten ausgebildet. Zusätzliche Funktionalität besitzt die Unterwasser-Schalteinheit nur hinsichtlich der Schnittstelleneinheit sowie ggf. zur vorbeschriebenen Statusabfrage.

Alternativ können die Schaltelemente auch als Relais ausgebildet werden, wobei es sich dann um besonders einfach zu montierende Unterwasser-Schalteinheit handelt.

Vorzugsweise ist das Gehäuse wasserdicht vergossen ausgebildet. Wasserdicht meint hierbei die Erfüllung Norm gemäß IP 68.

Alternativ oder ergänzend ist die Elektronikeinheit mit der Datenbusschnittstelle und dem Schaltelement in einer wasserdichten Vergussmasse insbesondere auf einer einzigen Platine angeordnet, wodurch ein zusätzlicher oder ergänzender Schutz bewirkt wird. Durch die Bestückung einer einzigen Platine mit den jeweiligen Bauteilen wird die Herstellung der erfindungsgemäßen Unterwasser-Schafteinheit vereinfacht.

Zum Schutz der insbesondere elektronischen Schaltelemente ist jedem Ausgangsanschluss eine Freilaufdiode zugeschaltet, so dass beispielsweise bei der Ausschaltung von Magnetventilen entstehende Spannungsspitzen unkritisch für das Schaltelement abgebaut werden können.

Eine Erhöhung der Betriebssicherheit ist weiterhin dann gegeben, wenn die Datenbus-Schnittstelle galvanisch von dem Betriebsspannungspotenzial bzw. dem zugehörigen Schaltkreis getrennt ist.

Die Datenbus-Schnittstelle kann hierbei dennoch Teil der Elektronikeinheit sein, die zur Steuerung der Schaltelemente vorhanden ist. Es kann sich jedoch auch um eine separate Einheit handeln.

Zur Ansteuerung etwaiger an die Unterwasser-Schalteinheit anzuschließende Endgeräte ist es von Vorteil, wenn die Unterwasser-Schalteinheit zumindest eine über den Datenbus-Anschluss mit der Elektronikeinheit verbindbare, separat von dem Gehäuse aufstellbare Steuereinheit in Form einer vorprogrammierten oder programmierbaren Steuerung umfasst. Hierbei kann es sich um eine beispielsweise über eine kabellos mit einem Steuerelement (Sender-Empfängerelement) verbundene Fernbedienung handeln, über die einzelnen Funktionen der Unterwasser-Schalteinheit aktiviert bzw. abgefragt werden können. Es kann sich auch um eine Computerprogrammsteuerung handeln, die über einen PC, Tablet-PC, Smartphone oder dergleichen EDV-Anlagen realisiert werden kann.

Weitere Vorteile und Einzelheiten der Erfindung lassen sich der nachfolgenden Figurenbeschreibung entnehmen.

In den nachfolgenden schematisch dargestellten Figuren zeigt:
- Fig. 1: eine schematische Darstellung eines erfindungsgemäßen Gegenstands,
- Fig. 2: den Gegenstand nach Fig. 1 mit anzuschließenden Endgeräten,
- Fig. 3: einen weiteren erfindungsgemäßen Gegenstand mit einer gegenüber der Fig. 2 größeren Anzahl an Endgeräten,
- Fig. 4: einen weiteren erfindungsgemäßen Gegenstand,
- Fig. 5: den Gegenstand nach Fig. 4 in einer weiteren Ausbildung.

Gleich oder ähnlich wirkende Teile sind - sofern dienlich - mit identischen Bezugsziffern versehen. Einzelne technische Merkmale der nachfolgend beschriebenen Ausführungsbeispiele können gemeinsam mit den Merkmalen des Hauptspruchs sowie ergänzend mit Merkmalen vorbeschriebener Ausführungsbeispiele zu erfindungsgemäßen Weiterbildungen führen.

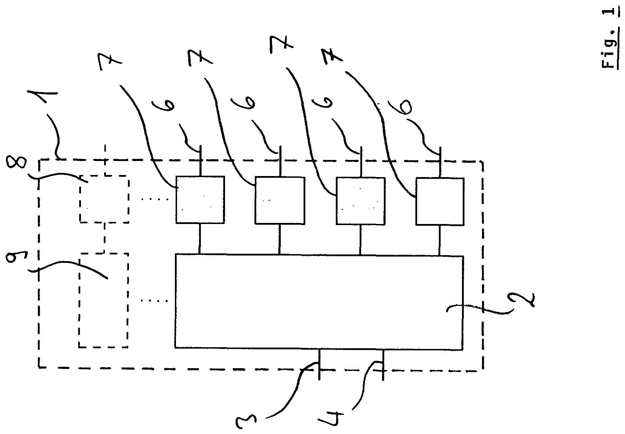

In dem Blockschaltbild der Fig. 1 sind die Elemente einer erfindungsgemäßen Unterwasser-Schalteinheit durch eine gestrichelte Linie 1 umgrenzt. Die Unterwasser-Schalteinheit ist im vorliegenden Fall zur Spannungsversorgung von Unterwasserleuchten vorgesehen, die auch unter der Wasseroberfläche in einem Teich angeordnet werden können. Insofern kennzeichnet die Linie 1 ein wasserdicht gemäß Norm IP 68 ausgebildetes Gehäuse, in dem eine Elektronikeinheit 2 angeordnet ist. Die Elektronikeinheit 2 wird über eine Leitung 3 mit einer Eingangsspannung, insbesondere 24 Volt Gleichstrom, versorgt. Über eine Datenbusleitung 4 erfolgt die Übermittlung eines Informationssignals betreffend die Spannungsbeaufschlagung eines oder mehrerer der Ausgangsanschlüsse.

Die Ausgangsanschlüsse sind durch vier durchgezogene Leitungen 6, die die gestrichelte Linie 1 kreuzen, dargestellt.

Über die Elektronikeinheit 2, die eine nicht näher dargestellte Datenbus-Schnittstelle aufweist, ist eine über einen Eingangsanschluss anlegbare Eingangsspannung auf die Ausgangsanschlüsse der Unterwasser-Schalteinheit parallel verteilbar. Jedem der Ausgangsanschlüsse ist ein Schaltelement in Form eines Leistungs-MOSFETs (Power-MOSFET) 7 zugeordnet. Gestrichelt ist eine Erweiterungsstufe der erfindungsgemäßen Unterwasser-Schalteinheit dargestellt mit einem weiteren Schaltelement 8 und einem zugehörigen Teil 9 der Elektronikeinheit. Beispielsweise kann die Elektronikeinheit Anschlüsse für weitere vier Ausgänge aufweisen, so dass insgesamt acht Geräte separat mit der Eingangsspannung beaufschlagt von derselben Unterwasser-Schalteinheit versorgt werden können.

Über die Datenbusleitung 4 können von der Unterwasser-Schalteinheit Informationen über den über die Ausgangsleitungen 6 fließenden Strom, den Schaltzustand der Schaltelemente 7 und 8, die dort anliegende Spannung sowie die Temperatur der Elektronikeinheit an eine Steuereinheit geliefert werden. Einen über das Beaufschlagen mit bzw. Abschalten der Spannung hinausgehende Regelung der an den Anschlüssen angeordneten Endgeräte kann mit der vorliegenden Unterwasser-Schalteinheit nicht realisiert werden. Die Vorteile der erfindungsgemäßen Unterwassereinheit sind gerade in der Einfachheit ihres Aufbaus zu sehen.

Im Regelbetrieb können die eingesetzten Transistoren, im vorliegenden Fall Power-MOSFETs, einen Strom von 2,5 A leiten. Dieser dient beispielsweise für den Betrieb von LED- oder Halogen-Unterwasserscheinwerfern. Beim Ausschalten beispielsweise von induktiven Lasten wie Magnetventilen können Stromspitzen von bis zu 13 A von dem Schalterelement verkraftet werden, alternativ kann dieses wie auch die Elektronikeinheit 2 über eine Freilaufdiode geschützt werden.

Falls versehentlich Spannungsquellen am Ausgang angeschlossen werden, was bei Systemsteckern identischer Bauart sowohl auf der Eingangs- wie auf der Ausgangsseite passieren kann, kann jedem Ausgang eine Schutzdiode zugeordnet sein, die für Spannungsquellen bis 16 A ausgelegt ist.

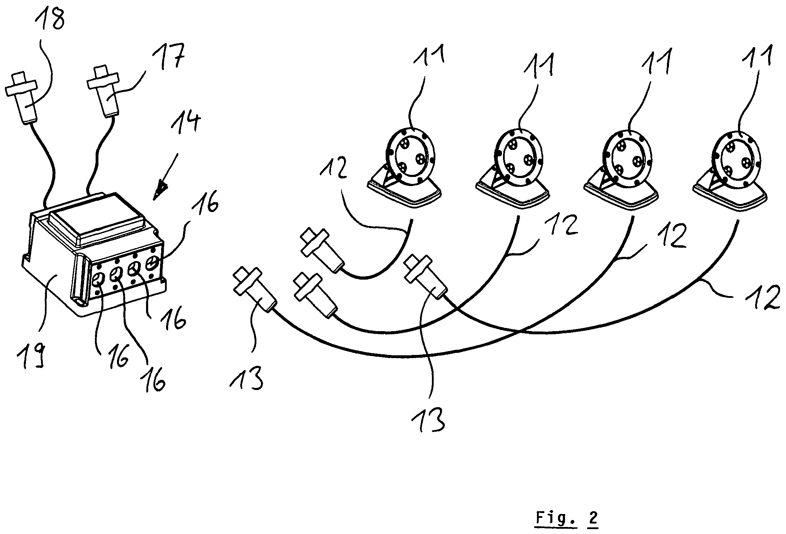

Entsprechende Systemstecker mit den auf Seiten der Unterwasser-Schalteinheit vorzusehenden Anschlüssen sind in der Fig. 2 dargestellt. Als zu versorgende Endgeräte sind hier Leuchtmodule 11 vorgesehen, die über Anschlussleitungen 12, die endseitig mit Systemsteckern 13 versehen sind, mit der Unterwasser-Schalteinheit 14 verbindbar. Hierfür sind die Systemstecker 13 wasserdicht mit Ausgangsanschlüssen 16 verbindbar.

Auch auf der Eingangsseite sind Systemstecker 17 für die Spannungsversorgung und 18 für das Datenbuskabel vorgesehen.

Das gesamte Gehäuse 19 ist wasserdicht ausgebildet. Intern ist die Elektronikeinheit 2 mit einer Platine versehen, auf der die jeweiligen Bauteile wie Bus-Schnittstelle, Schaltelemente 7 sowie ggf. eine EEPROM-Einheit für die Firmware des Geräts, wasserdicht vergossen sind.

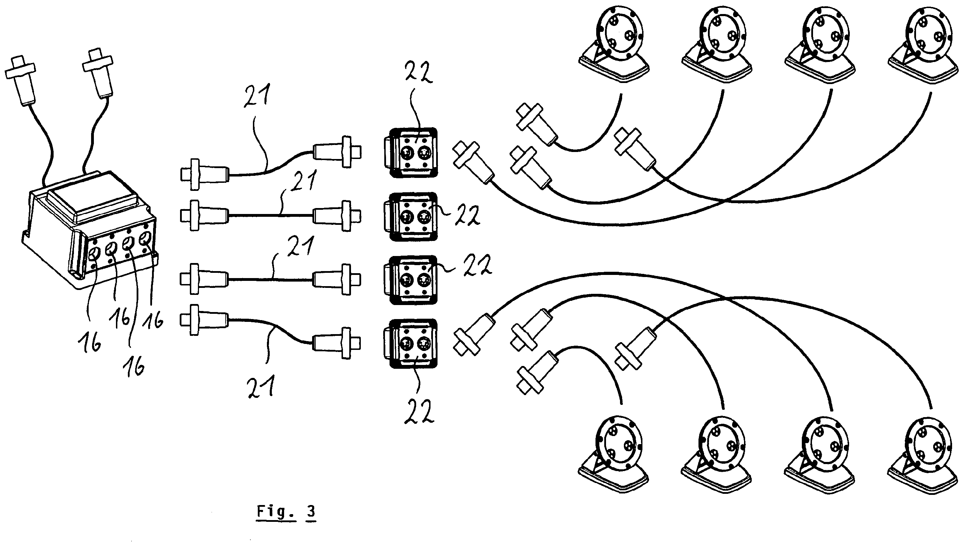

Im Ausführungsbeispiel gemäß der Fig. 3 umfasst dieses zusätzlich zu den bereits in der Fig. 2 vorbeschriebenen Komponenten zusätzliche, mit Systemsteckern versehene Anschlusskabel 21, über die jeweils an einen Ausgangsanschluss 16 anschließbare Verteiler 22 mit Strom beaufschlagt werden können.

Jedem Verteiler 22 ist dann eine Mehrzahl von Endgeräten (im vorliegenden Fall zwei) in Form von Leuchtmodulen zugeordnet, so dass über die vier Ausgänge insgesamt acht Leuchtmodule in Form von vier Gruppen á zwei Modulen betrieben werden können.

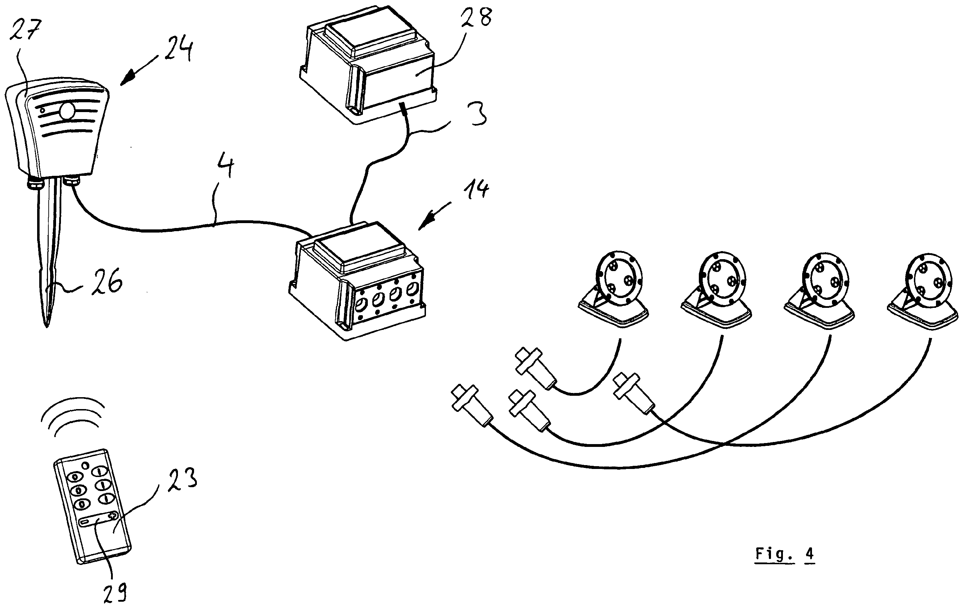

Eine erfindungsgemäße Weiterbildung (Fig. 4) ist mit einer vorprogrammierten Steuereinheit versehen, die in Form einer Fernbedienung 23, die drahtlos Signale an einen Signalempfänger 24 leiten kann, und dem Signalempfänger, welcher wiederum mit einem Datenkabel mit der Unterwasser-Schalteinheit 14 verbunden ist, ausgebildet ist. Die Empfangseinheit 24 ist über ein pfeilartiges Befestigungselement 26 im Erdreich nahe einem Teich befestigbar. Ihr Gehäuse 27 ist öffnungsfähig und mit einer Batterie oder einem Wechselakku versehen. Alternativ oder ergänzend können Photovoltaikelemente in der Gehäuseoberfläche integriert sein, um eine langfristige Stromversorgung der Empfangseinheit 24 zu gewährleisten.

An dem Eingangsanschluss ist über eine Leitung 3 ein Transformator 28 angeordnet, der ebenfalls wasserdicht ausgebildet, jedoch auch außerhalb des Wassers angeordnet sein kann.

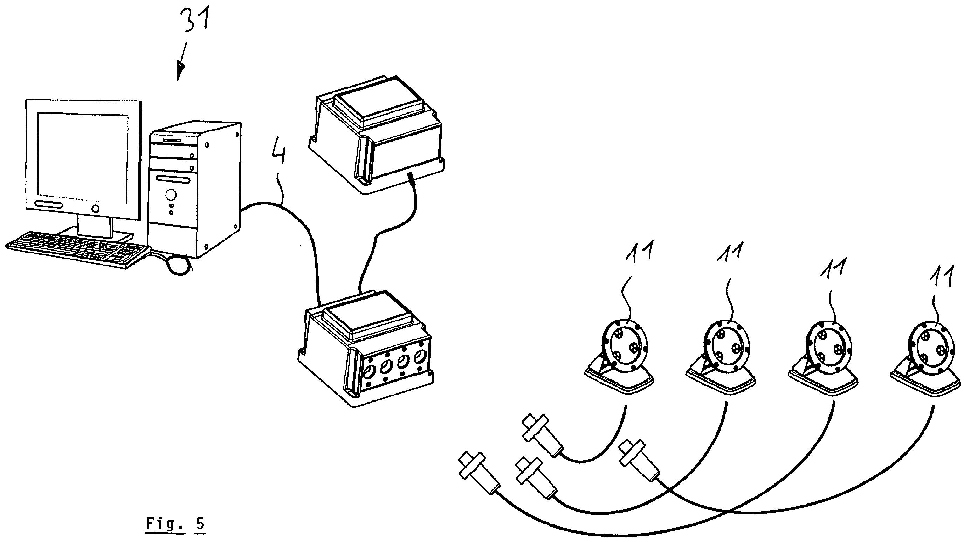

Über die Steuereinheit können im vorliegenden Fall die in drei Gruppen eingeteilten vier Leuchtmodule an und ausgeschaltet werden (Bedienelemente "0" und "1"). Über einen Schalter 29 können einzelne Leuchtmodule hinzu- oder abgeschaltet werden. Anstelle einer solchen vorgegebenen bzw. vorprogrammierten Steuerung kann an dem Datenkabel 4 auch eine EDV-Einheit 31 angeschlossen sein, über die die Leuchtmodule 11 oder andere an der erfindungsgemäßen Unterwasser-Schalteinheit angeordnete Endgeräte frei programmierbar ein- und ausgeschaltet werden können (Fig. 5).

## Patentansprüche

1. Unterwasser-Schalteinheit, zur Spannungsversorgung von Elektrogeräten (11), mit einem vorzugsweise wasserdicht ausgebildetem Gehäuse (19), in dem eine Elektronikeinheit (2) angeordnet ist, mit der eine über einen Eingangsanschluss der Unterwasser-Schalteinheit (14) anlegbare Eingangsspannung auf zumindest einen Ausgangsanschluss (16) der Unterwasser-Schalteinheit (14) schaltbar ist, wobei die Unterwasser-Schalteinheit (14) einen Datenbus-Anschluss mit zugehöriger Datenbus-Schnittstelle umfasst, über die ein Informationssignal betreffend die Spannungsbeaufschlagung eines Ausgangsanschlusses (16) erfassbar ist, wobei die Unterwasser-Schalteinheit keine Verarbeitung von Regelsignalen zur Steuerung der angeschlossenen Elektrogeräte vornehmen kann, wobei mit der Unterwasser-Schalteinheit (14) die Eingangsspannung auf mehrere Ausgangsanschlüsse (16) verteilbar ist, wobei zumindest zwei der Ausgangsanschlüsse (16) über zumindest ein Schaltelement (7,8) der Unterwasser-Schalteinheit (14) separat voneinander spannungsbeaufschlagt werden können und wobei die Unterwasser-Schalteinheit (14) zumindest eine über den Datenbus-Anschluss mit der Elektronikeinheit (2) verbindbare, separat von dem Gehäuse (19) aufstellbare Steuereinheit (31) zur vorprogrammierten oder programmierbaren Steuerung der Elektrogeräte (11) umfasst.

2. Unterwasser-Schalteinheit nach Anspruch 1, **dadurch gekennzeichnet, dass** jedem Ausgangsanschluss (1) jeweils ein Schaltelement (7,8) zugeordnet ist.

3. Unterwasser-Schalteinheit nach einem der Ansprüche 1 oder 2, **dadurch gekennzeichnet, dass** das Schaltelement (7,8) auf eine Schaltfrequenz von mindestens 100 Hz ausgelegt ist.

4. Unterwasser-Schalteinheit nach einem der vorherigen Ansprüche, mit zumindest zwei Schaltelementen (7,8), **dadurch gekennzeichnet, dass** die Schaltelemente (7,8) jeweils elektronische Schaltelemente (7,8) sind, die insbesondere als Transistor, Thyristor oder Triac ausgebildet sind.

5. Unterwasser-Schalteinheit nach einem der vorherigen Ansprüche, mit zumindest zwei Schaltelementen, **dadurch gekennzeichnet, dass** die Schaltelemente jeweils als Relais ausgebildet sind.

6. Unterwasser-Schalteinheit nach einem der vorherigen Ansprüche, **dadurch gekennzeichnet, dass** die Elektronikeinheit (2) mit der Datenbus-Schnittstelle und dem Schaltelement (7,8) in einer wasserdichten Vergußmasse insbesondere auf einer einzigen Platine angeordnet ist.

7. Unterwasser-Schalteinheit nach einem der vorherigen Ansprüche, **dadurch gekennzeichnet, dass** das Gehäuse (19) wasserdicht vergossen ausgebildet ist.

8. Unterwasser-Schalteinheit nach einem der vorherigen Ansprüche, **dadurch gekennzeichnet, dass** jedem Ausgangsanschluss (16) eine Freilaufdiode zugeschaltet ist.

9. Unterwasser-Schalteinheit nach einem der vorherigen Ansprüche, **dadurch gekennzeichnet, dass** die Datenbus-Schnittstelle galvanisch von dem Betriebsspannungspotential getrennt ist.

10. Unterwasser-Schalteinheit nach einem der vorherigen Ansprüche, **gekennzeichnet durch** zumindest einen an einen Ausgangsanschluss (16) anschließbaren Verteiler (22), über den mehrere Elektrogeräte (11) an einen Ausgangsanschluss (16) anschließbar sind.

## Claims

1. Underwater switch unit, for supplying voltage to electrical devices (11), comprising a preferably water-tight housing (19) in which an electronic unit (2) is arranged, by means of which electronic unit an input voltage that can be applied via an input terminal of the underwater switch unit (14) can be switched to at least one output terminal (16) of the underwater switch unit (14), wherein the underwater switch unit (14) comprises a data bus terminal that has an associated data bus interface by means of which an information signal relating to the voltage supply to an output terminal (16) can be detected, wherein the underwater switch unit cannot carry out processing of control signals for controlling the connected electrical devices, wherein the input voltage can be distributed to a plurality of output terminals (16) by means of the underwater switch unit (14), wherein at least two of the output terminals (16) can be supplied with voltage separately from one another by means of at least one switch element (7, 8) of the underwater switch unit (14) and wherein the underwater switch unit (14) comprises at least one control unit (31) for pre-programmed or programmable control of the electrical devices (11), which unit can be connected to the electronic unit (2) by means of the data bus terminal and mounted separately from the housing (19).

2. Underwater switch unit according to claim 1, **characterised in that** a switch element (7, 8) is associated with each output terminal (1).

3. Underwater switch unit according to either claim 1 or claim 2, **characterised in that** the switch element (7, 8) is designed to have a switching frequency of at least 100 Hz.

4. Underwater switch unit according to any of the preceding claims, comprising at least two switch elements (7, 8), **characterised in that** the switch elements (7, 8) are electronic switch elements (7, 8), in particular designed as transistors, thyristors or triacs.

5. Underwater switch unit according to any of the preceding claims, comprising at least two switch elements, **characterised in that** the switch elements are designed as relays.

6. Underwater switch unit according to any of the preceding claims, **characterised in that** the electronic unit (2), together with the data bus interface and the switch element (7, 8), is arranged in a water-tight potting compound, in particular on a single printed circuit board.

7. Underwater switch unit according to any of the preceding claims, **characterised in that** the housing (19) is potted so as to be water-tight.

8. Underwater switch unit according to any of the preceding claims, **characterised in that** a flyback diode is connected to each output terminal (16).

9. Underwater switch unit according to any of the preceding claims, **characterised in that** the data bus interface is galvanically separated from the operating voltage potential.

10. Underwater switch unit according to any of the preceding claims, **characterised by** at least one distribution board (22) which can be connected to an output terminal (16) and via which a plurality of electrical devices (11) can be connected to an output terminal (16).

## Revendications

1. Boîte de commutation submersible pour l'alimentation en courant d'appareils électriques (11), avec un boîtier (19) réalisé de préférence de manière étanche à l'eau et dans lequel est disposée une unité électronique (2) permettant de commuter une tension d'entrée pouvant être appliquée par un port d'entrée de la boîte de commutation submersible (14) à au moins un port de sortie (16) de la boîte de commutation submersible (14), dans laquelle ladite boîte de commutation submersible (14) comprend un port de bus de données avec une interface de bus de données associée par laquelle un signal d'information concernant l'alimentation en courant d'un port de sortie (16) peut être détecté, dans laquelle la boîte de commutation submersible ne peut pas procéder au traitement des signaux de commande pour commander les appareils électriques connectés, dans laquelle la boîte de commutation submersible (14) permet de distribuer la tension d'entrée sur plusieurs ports de sortie (16), dans laquelle au moins deux des ports de sortie (16) peuvent être alimentés en courant séparément l'un de l'autre par au moins un élément de commutation (7, 8) de la boîte de commutation submersible (14), et dans laquelle la boîte de commutation submersible (14) comprend au moins une unité de commande (31) pouvant être connectée à l'unité électronique (2) par l'intermédiaire du port de bus de données, et pouvant être installée séparément du boîtier (19), pour la commande préprogrammée ou programmable des appareils électriques (11).

2. Boîte de commutation submersible selon la revendication 1, **caractérisée en ce que** respectivement un élément de commutation (7, 8) est attribué à chaque port de sortie (1).

3. Boîte de commutation submersible selon les revendications 1 ou 2, **caractérisée en ce que** l'élément de commutation (7, 8) est conçu pour une fréquence de commutation d'au moins 100 Hz.

4. Boîte de commutation submersible selon l'une quelconque des revendications précédentes, avec au moins deux éléments de commutation (7, 8), **caractérisée en ce que** les éléments de commutation (7, 8) sont respectivement des éléments de commutation (7, 8) électroniques, réalisés en particulier sous la forme d'un transistor, d'un thyristor ou d'un triac.

5. Boîte de commutation submersible selon l'une quelconque des revendications précédentes, avec au moins deux éléments de commutation, **caractérisée en ce que** les éléments de commutation sont respectivement réalisés sous la forme de relais.

6. Boîte de commutation submersible selon l'une quelconque des revendications précédentes, **caractérisée en ce que** l'unité électronique (2) est disposée avec l'interface de bus données et l'élément de commutation (7, 8) dans une masse de scellement étanche à l'eau, en particulier sur une seule platine.

7. Boîte de commutation submersible selon l'une quelconque des revendications précédentes, **caractérisée en ce que** le boîtier (19) est réalisé en étant scellé de manière étanche à l'eau.

8. Boîte de commutation submersible selon l'une quelconque des revendications précédentes, **caractérisée en ce qu'**une diode de roue libre est mise en circuit avec chaque port de sortie (16).

9. Boîte de commutation submersible selon l'une quelconque des revendications précédentes, **caractérisée en ce que** l'interface de bus de données est séparée galvaniquement du potentiel de tension de service.

10. Boîte de commutation submersible selon l'une quelconque des revendications précédentes, **caractérisée par** au moins un distributeur (22) pouvant être connecté à un port de sortie (16) et par lequel plusieurs appareils électriques (11) peuvent être connectés à un port de sortie (16).
